# EUROPEAN PATENT SPECIFICATION

(11) **EP 3 792 984 B1**
(45) Date of publication and mention of the grant of the patent: **24.11.2021**
(21) Application number: 19197366.8
(22) Date of filing: 13.09.2019
(51) Int. Cl.: H01L 31/042, H01L 31/048, H02S 20/22

(54) **METHOD FOR MAKING A SOLAR MODULE**
VERFAHREN ZUR HERSTELLUNG EINES SOLARMODULS
MÉTHODE DE FABRICATION D'UN MODULE SOLAIRE

(43) Date of publication of application: 17.03.2021
(73) Proprietor: g-neration.energy AG, 3600 Thun (CH)
(72) Inventor: BESNIK, Kiqina, 4562 Biberist (CH); BÄCKMANN, Marcus, 3645 Gwatt (CH)
(74) Representative: Patentbüro Paul Rosenich AG

(56) References cited:
- WO-A1-2018/042416
- US-A1- 2013 139 871
- US-A1- 2017 373 207

## Description

The invention relates to a method for making a solar module, also called a photovoltaic module, and a solar module.

With the increasing number of roof-mounted solar installations, the demand for more pleasing solutions is rising. Building Integrated Photovoltaics (BIPV) is one of the solutions. There remains a problem with roofs that are not rectangular, though, since special solar modules need to be made to cover e.g. slanted edges.

US 2013 139871 A1 discloses a solar cell module. The solar cell module comprises a light-receiving-surface-side sealing material and a non-light-receiving-surface-side sealing material. The sealing materials are applied by a lamination process.

From US 6525262 B1 a triangular module is known with rectangular cells. This clearly leads to a difference in appearance in the region of the module where there are no solar cells.

From EP 3090484 A1 imitation solar modules are known that contain a visual representation of a portion of a photovoltaic module displayed on a portion thereof.

The objects of the present invention are to provide a solar module that can be efficiently and cost-effectively made and can have any shape.

At least one of these objects is achieved by the method according to claim 1 and a solar module according to claim 6.

In a first aspect of the invention, a method for forming a solar module (9) consisting of the steps of a) providing at least one solar cell (3), b) providing a first sheet of encapsulant (2), c) adhering at least partly the at least one solar cell (3) to the first sheet of encapsulant (2) forming an adhering portion (14) between the at least one solar cell (3) and the first sheet of encapsulant (2) and d) cropping that at least one solar cell (3) that is adhered to the first sheet of encapsulant (2) in the adhering portion (14) along a cropping line (6) with cutting means (13), wherein step c) being carried out prior to step d).

Preferably steps a) and b) are carried out prior to step c).

Since the solar cells, that may and may not be operatively connected, can be adhered to the sheet of encapsulant, in advance, prior to knowing the exact shape of the final module that is, the production process is simplified: stick solar cells to a sheet of encapsulant, store them and cut them to shape when a solar cell with a deviating shape need to be made, thus leading to the desired goals.

Preferably the cutting means in step d) comprise at least one cutting blade, preferably only comprise at least one cutting blade. In this way the encapsulant adhered to the solar cell(s) to be cropped permits the cropping with at least one cutting blade without the cell breaking in an undesired manner.

As used in this document "cropping" is the act of completely severing a part of an object.

By cropping solar cells with at least one cutting blade, cost can be reduced as compared to more expensive options such as laser cutting. The cropping edge is more rugged as compared to e.g. cells that are cut by laser, but that does not hinder for the current purpose since the general appearance is not impaired.

Moreover, in this way, the cells can be made to size in an easy way: by cropping it with at least one cutting blade such as a pair of scissors, a punch, a (rotary) knife or a saw. All those cutting means have many different embodiments that may all be used. Also, solar cells that are not up to standard may be used for the cells that are not operatively connected.

As used in this document "at least one cutting blade" or "cutting blade" are any means that use at least one cutting blade (pair of scissors, knife, saw) or cutting wire (wire saw). The cutting blade and or cutting wire may have teeth or cutting elements attached thereto or may have a smooth cutting edge. They may rotate or oscillate and be handheld or automatic. The respective cutting blade(s) as a cutting means is chosen according to the material that has to be cut.

Preferably essentially no other cutting means, such as laser, are used for cutting the solar cells. In this way no expensive equipment is needed.

As is known by a person skilled in the art, solar modules can be made by laminating a stack consisting of cover layer, mostly a sheet of glass, a first encapsulant layer, a string or matrix of solar cells, a second encapsulant layer and a back sheet or a second sheet of glass. The lamination normally takes place under vacuum. Optionally by-pass diodes and interconnectors for strings may be provided. Finally, cables are attached to the operative cells in the module for connecting the solar module to a load or other solar modules.

For a general description on how solar modules are laminated, reference is made to e.g. EP 2525976 A2, WO 2011089474 A2 or EP 2735378 A1, all of which are hereby incorporated herewith by reference in their entirety.

In this document "solar modules" refer to any laminate with solar cells in it. The cells may be operationally connected, may not be operationally connected or any combination thereof.

"wafer-based solar cells" may be all solar cells made from a wafer of brittle materials such as silicon, Gallium arsenide and may be produces by e.g. cutting an ingot or block of material or a kerfless procedure

Preferably in step c) the adhering portion is made to extend over mainly the complete surface of the at least one solar cell, so that the encapsulant holds the cell during cropping as well as later when the cell is processed.

Preferably the method for forming a solar module comprises a further step e) of providing a second sheet of encapsulant, preferably prior to step c), and prior to step d) adhering the at least one solar cell to the second sheet of encapsulant and/or adhering the second sheet of encapsulant to the first sheet of encapsulant, so that the cell is protected even more and the (cut) laminate can be treated more easily. Also, the cropping edge becomes less rugged.

Preferably in step c) the at least one solar cell that is adhered to the first sheet of encapsulant and/or second sheet of encapsulant is adhered thereto by applying glue, heat, ultra-sound, electrostatic forces or any combination thereof, preferably while a vacuum is applied. Applying heat is especially beneficial because the encapsulant will become sticky and thus better adhere to the solar cell(s) to be cropped. Moreover, no additional materials such as adhesives are needed.

Preferably the method further comprises the step e) of forming a solar module out of the at least one cropped cell, preferably also using the first sheet of encapsulant and/or second sheet of encapsulant, even more preferably leaving the first sheet of encapsulant and/or second sheet of encapsulant adhered to the at least one cropped solar cell. These measures enable the cost-effective production of solar cells. Preferably in step d) the first sheet of encapsulant and/or second sheet of encapsulant are cropped while cropping the at least one solar cell so that the cropped of portion of the at least one solar cell can be removed with the cut-off part of the encapsulant.

Preferably in step c) the encapsulant and the at least one solar cell are laminated between release sheets in a laminator, the release sheets preferably containing Polytetrafluorethylen (as e.g. Teflon® from DuPont) so that the stack of encapsulant and solar cells do so stick to the laminator.

Preferably the method further comprises the steps of making a stack containing a cover element such as a sheet of glass and the at least one cropped solar cell and preferably the first sheet of encapsulant and or second sheet of encapsulant, laminating the stack in a laminator, preferably under vacuum, optionally adding to the stack any of at least one additional sheet or piece of encapsulant, a back sheet, at least one additional solar cell, a string or matrix of solar cells, the solar cells preferably being operationally connected, interconnectors, by-pass diodes, further cropped solar cells or any combination thereof. These measures allow to produce solar modules efficiently.

Preferably the cover element has the shape of the final solar module so that the cover element does not need to be cut after lamination which could harm the cells.

Preferably in step a) a damaged solar cell is provided so that they can be made to use thus reducing total costs of the solar module.

Preferably in step d) the cropping line is chosen essentially parallel to at least one of the edges of the solar module and/or at a distance from the edges of the solar module. In this way not water can ingress into the module through the cropped solar cell.

Essentially parallel in the relation of the cropping line and the module edges means that they may make an angle smaller than 20°, preferably smaller than 10° even more preferably smaller than 5°.

Preferably in step d) the cropped off portion of the cropped solar cell is cropped off the solar cell completely by the at least one cutting blade so that no other equipment is needed.

In a further aspect of the invention, a solar module manufactured according to the inventive method is provided. Since the solar cells, that may and may not be operatively connected, can be adhered to the sheet of encapsulant, in advance, prior to knowing the exact shape of the final module that is, the production process is simplified: stick solar cells to a sheet of encapsulant, store them and cut them to shape when a solar cell with a deviating shape need to be made, thus leading to the desired goals.

According to the invention the at least one solar cell is cropped with at least one cutting blade, preferably the at least one solar cell (3) is only cropped with at least one cutting blade (13), even more preferably by mechanical means only. In this way the encapsulant adhered to the solar cell(s) to be cropped permits the cropping with at least one cutting blade without the cell breaking in an undesired manner. By cropping solar cells with at least one cutting blade, cost can be reduced as compared to more expensive options such as laser cutting. The cropping edge is more rugged as compared to e.g. cells that are cut by laser, but that does not hinder for the current purpose since the general appearance is not impaired.

Moreover, in this way, the cells can be made to size in an easy way: by cropping it with at least one cutting blade such as a pair of scissors, a punch, a (rotary) knife or a saw. All those cutting means have many different embodiments that may all be used. Also, solar cells that are not up to standard may be used for the cells that are not operatively connected.

In this document "mechanical means" comprise all suitable cutting means excluding laser.

Preferably the at least one solar cell is a wafer-based solar cell, preferably a mono-crystalline solar cell, multi-crystalline solar cell or multi-like mono-crystalline solar cell so that modules with standard solar cells can be made.

Preferably essentially no other cutting means, such as laser, are used for cutting the solar cells. In this way no expensive equipment is needed.

Preferably the cropping line of the at least one cropped solar cell runs essentially parallel to at least one of the edges of the solar module so that a distance between the edge of the solar module and the cells can be maintained small, while being large enough to prevent leak currents. Essentially parallel in the relation of the cropping line and the solar module edges means that they may make an angle smaller than 20°, preferably smaller than 10° even more preferably smaller than 5°.

For the same reason the cropping line preferably extends through at least two, preferably at least four adjacent solar cells, these solar cells all being cropped along this cropping line and/or the cropping line extends preferably mainly in parallel to the edges of the solar module.

Preferably the cropping line is a straight line so that the solar module can be made efficiently, but this need not be the case when for example a chimney pipe must be (partially) fit through the solar module. Preferably the cropping line extends though the metallization on the cropped solar cell so that the shape of the solar module does not depend on the metallization.

Preferably the cropping line does not essentially coincide with the (xxx) plane of the crystal lattice of the cropped solar cell, x being selected from {0,1}. Otherwise the solar cell could break along that lattice plane.

Preferably the cropping line extends at a distance from the edges of the solar module (9) so that the cropped solar cell does not form a path for moister to ingress into the solar module.

Preferably the solar module contains at least one solar cell, preferably multiple identical solar cells without a cropped off portion. If these solar cells are operationally connected, they can be used to produce electrical energy. They may however also serve for aesthetical purposes.

Preferably the solar module contains multiple cropped solar cells, preferably cropped from the same type of solar cell as the at least one non-cropped solar cell (4, 5) so that the solar module may have more complex shapes such as a triangular or trapezoid shape. The edge of the solar modules may have convex and concave portions. Also portions of the edge of the solar module may be curved, e.g. for a chimney pipe to pass through.

Preferably the solar module may have at least two edges, the smallest angle between them forming an angle between 5° and 85° or between 95° and 175° in the plane of the solar module.

Accordingly, the at least one cropped solar cell may have at least two edges, the smallest angle between them forming an angle between 5° and 85° or between 95° and 175° in the plane of the solar module.

Preferably the solar module contains a portion with at least one straight solar cell string or solar cell matrix, preferably a rectangular matrix, these cells preferably being at least partially operatively connected so that normal production equipment can be used.

Preferably at least one solar cell (5), preferably multiple solar cells, are provided that are operatively connected so that the solar module can produce electrical energy in useful amounts in a cost-effective manner.

By at least one cropped solar cell is made from the same type of solar cell as at least one non-cropped solar cell in the module (4, 5) so that one type of solar cell can be used, thus simplifying the production process. With "type of cell", especially their appearance is meant. Slight differences are acceptable as long as the solar cells appear identical during use of the solar module.

Preferably the number of non-cropped solar cells in the solar module is larger than the number of cropped solar cells, preferably by a factor of 2, even more preferably by a factor of 4 so that a decent amount of energy can be produced relative to the size of the solar module.

Preferably at least one of the at least one cropped solar cell (3) and/or at least one of the non-cropped solar (4) cells are not operatively connected so that the solar module can be filled up while keeping the path the current must take simple and thus production costs low.

Operatively connected in this document means that the solar cells contribute to the output power of the solar module.

In this document, the output of the solar module may e.g. be the cables used for attaching it to other solar modules or to a load such as e.g. an inverter. The output power accordingly is the electrical power provided at the output.

Preferably any of the cropped solar cell(s) and non-cropped solar cell(s) are or are made from full-square or pseudo-square solar cells, since these are used most in solar modules.

In a further aspect of the invention a method for cutting a solar cell is provided, comprising the steps of adhering a polymer sheet to the solar cell, preferably adhering at least two sheets to opposite sides of the solar cell, thus forming at least one adhering portion and cutting the solar cell in that adhering portion with at least one cutting blade so that the solar cells can be cut easily and without breaking in an undesired manner.

Preferably the polymer sheet is adhered to the solar cell by glue, heat, ultra-sound, electrostatic forces or any combination thereof, preferably while a vacuum is applied

Preferably the method for forming a solar module, comprises the steps of cutting the solar cell as described above and forming a solar module out of the cut cell, preferably also incorporating the at least one polymer sheet in the solar module.

Preferably the at least one polymer sheet is a sheet of encapsulant so that the polymer sheet can become part of the solar module.

For the present invention any encapsulant as commonly known (see e.g. WO 2012127344 A1, herewith incorporated by reference in their entirety.) can be used, including, but not limited to thermosetting materials e.g. comprising EVA, thermoplastic materials e.g. comprising TPO, PVB, POE Silicone or any combination thereof.

The sheet of encapsulant preferably is an encapsulant foil so that it can be handled easily.

The invention may also be used in combination with other energy harvesting means such as a solar thermal collector.

Any type of wafer-based solar cell may be used such as, but not limited to mono-crystalline solar cells, multi-crystalline solar cells, multi-like mono-crystalline solar cells, hetero-junction solar cells, back contact solar cells, IBC solar cells, solar cells comprising Perovskite, full-square solar cells, pseudo-square, half solar cells, bi-facial solar cells etc. Also, any metallization (any number of bus bars, pads etc.) and interconnection technology (ribbons, wires, shingling, gluing, soldering, bonding, etc.) may be used.

Further embodiments and aspects of the invention are indicated in the figures and in the claims. The list of reference marks forms part of the disclosure. The invention will now be explained in detail with reference to the drawings.
- Figs. 1 to 4: show steps in making the inventive solar module.
- Fig. 5: shows an inventive solar module with rectangular solar cells.
- Figs. 6 to 7: show an alternative embodiment of the method for producing a solar module.

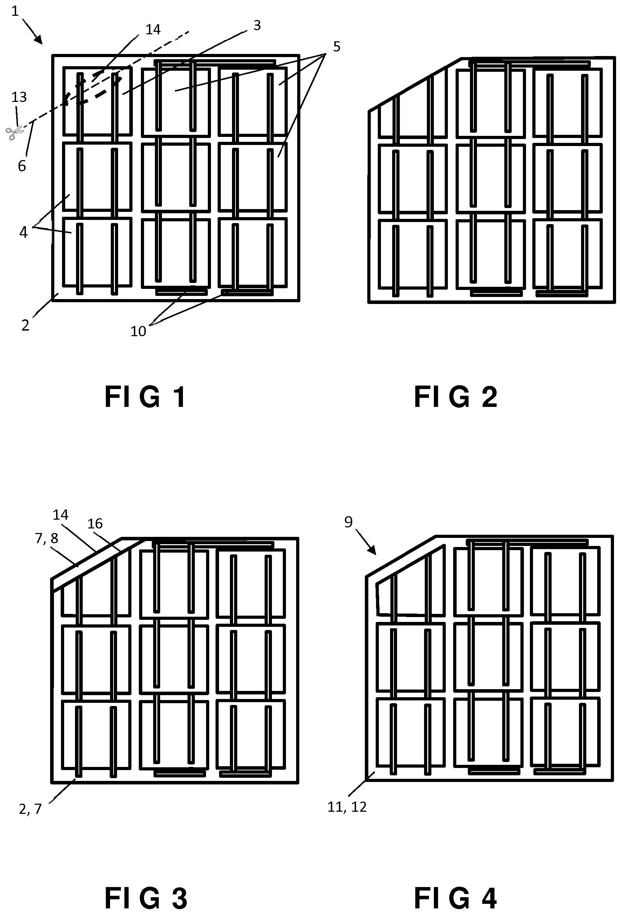

In figure 1 a solar cell 3 to be cropped and several solar cells that will not be cropped 4, 5 are shown laying on top of a sheet of encapsulant 2. This stack or layup is laminated in a laminator so that all solar cells, 3, 4, 5 adhere to the sheet of encapsulant 2. Solar cell 3 sticks to the first sheet of encapsulant 2 especially in an adhering portion 14.

The solar cells 3, 4, 5 may be adhered to the sheet of encapsulant in any laminator used to laminate solar modules. Preferably the stack is then sandwiched between release sheets so that the sheet of encapsulant (encapsulant layer) does not stick to any component parts of the laminator as it melts. Since not much heat is needed to stick the solar cells to the sheet of encapsulant, the lamination process can be quite short.

Alternatively, the solar cells may be stuck to the sheet of encapsulant using electrostatic charges as is e.g. known from WO 2012127344 A1, herewith incorporated by reference in their entirety. This process is even faster than lamination but requires additional equipment.

Once the solar cells and especially solar cell 3 are stuck in place, a cutting blade 13, here part of a pair of scissors, is used to crop the solar cell 3 along cropping line 6. Alternatively, e.g. rotating cutters may be used for cropping the solar cell.

The solar cells 4 are not operationally connected to the output terminals 10 of the solar module. This would complicate the stringing of the operative solar cells, thus making the solar module more expensive.

Figure 2 shows the layup of the solar module 1 after it has been cut.

The encapsulant with the solar cells stuck to it is now placed on a sheet of glass 7, as can be seen in figure 3. Since the cropped solar cell needs to be at a distance from the edge of what will be the solar module, an additional piece of the (sheet of) encapsulant 8 is placed on the glass next to cropping line 6. Now, the solar module layup is completed by placing a second sheet of encapsulant 11 and a second glass sheet 12 on top of the stack and the whole layup is laminated to form the final solar module laminate. Now a junction box may be attached. Normally building integrated photovoltaic (solar) modules do not have a frame and in that case the solar module is finished. As can be seen, cropping edge 16 of cell 3 extends in parallel to the solar module edge 15.

If so desired, all solar cells 3, 4, 5 are all not operationally connected, and no junction box is needed.

As can be seen from figure 4, the solar module 9 has the same appearance over its entire surface.

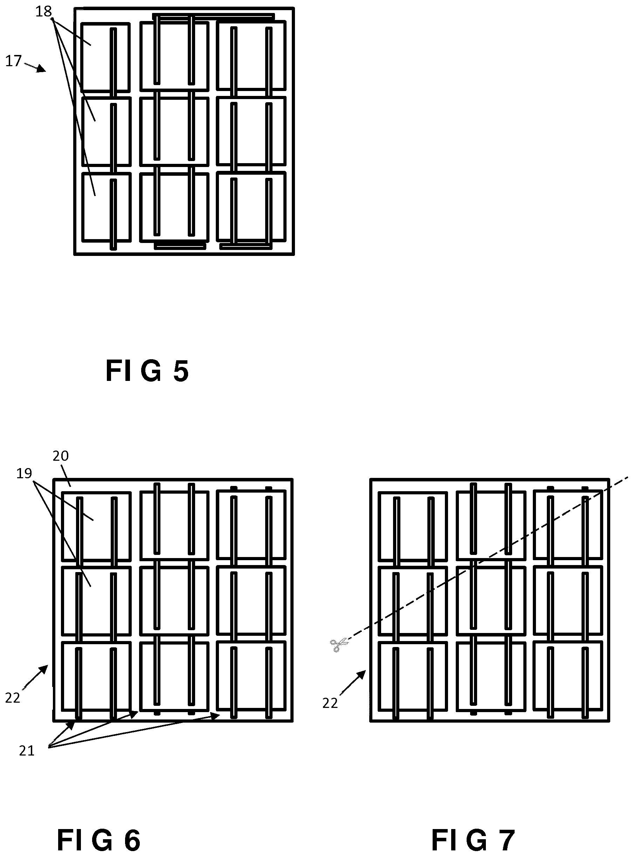

In figure 5 a final solar module 17 is shown that has rectangular cropped off solar cells 18.

Figure 6 shows solar cells 19, that in this case are all not operatively connected, adhered to a sheet of encapsulant 20. In order to keep the manufacturing process simple, the cells 19 are made into three strings 21. This ensures their proper positioning and can be done with equipment that is standard for solar module manufacturers. This assembly 22 can now be stored for later processing.

Once the shape of the final solar module is known, a glass cover in the desired shape is provided, the assembly 22 is cut accordingly, as is shown in figure 7 and the solar module produced, normally adding another layer of encapsulant and a back sheet or a second sheet of glass (not shown).

The invention is not restricted to these embodiments. Other variants will be obvious for the person skilled in the art and are considered to lie within the scope of the invention as formulated in the following claims. Individual features described in all parts of the above specification, particularly with respect to the figures may be combined with each other to form other embodiments and/or applied mutatis mutandis to what is described in the claims and to the rest of the description, even if the features are described in respect to or in combination with other features.

**Reference Marks**

| | | | |
|---|---|---|---|
| 1. | Layup for a solar module | 10. | Output terminals |
| 2. | Sheet of encapsulant | 11. | Second sheet of encapsulant |
| 3. | Cell to be cropped | 12. | Second glass sheet |
| 4. | Cell that will not be cropped | 13. | Cutting blade |
| 5. | Cell that will not be cropped | 14. | Adhering portion |
| 6. | cropping line | 15. | Solar module edge |
| 7. | Sheet of glass | 16. | Cropping edge |
| 8. | Piece of sheet of encapsulant | 17. | Solar module |
| 9. | Solar module | 18. | cropped off solar cells |

## Claims

1. Method for forming a solar module (9) consisting of the steps of:
a) providing at least one solar cell (3);
b) providing a first sheet of encapsulant (2);
c) adhering at least partly the at least one solar cell (3) to the first sheet of encapsulant (2) forming an adhering portion (14) between the at least one solar cell (3) and the first sheet of encapsulant (2); and
d) cropping that at least one solar cell (3) that is adhered to the first sheet of encapsulant (2) in the adhering portion (14) along a cropping line (6) with cutting means (13), wherein step c) being carried out prior to step d).

2. Method for forming a solar module according to claim 1, **characterized in that** the cutting means in step d) comprise at least one cutting blade (13), preferably only comprise at least one cutting blade (13).

3. Method for forming a solar module according to claim 1 or 2, **characterized in that** in step c) the adhering portion (14) is made to extend over mainly the complete surface of the at least one solar cell (3).

4. Method for forming a solar module according to any of the previous claims, further comprising the step e) of providing a second sheet of encapsulant (11), preferably prior to step c), and prior to step d) adhering the at least one solar cell (3) to the second sheet of encapsulant (11), preferably by applying glue, heat, ultra-sound, electrostatic forces or any combination thereof, preferably while a vacuum is applied, and/or adhering the second sheet of encapsulant (11) to the first sheet of encapsulant (2).

5. Method for forming a solar module according to any of the previous claims, **characterized in that** in step c) the at least one solar cell (3) that is adhered to the first sheet of encapsulant (2) is adhered thereto by applying glue, heat, ultra-sound, electrostatic forces or any combination thereof, preferably while a vacuum is applied.

6. Solar module (9) comprising at least one solar cell (3) and a first sheet of encapsulant (2), wherein the at least one solar cell (3) adheres at least partly to the first sheet of encapsulant (2) whereby an adhering portion (14) is formed between the at least one solar cell (3) and the first sheet of encapsulant (2), **characterized in that** the solar module (9) is manufactured with a method according to any of the claims 1 to 5, wherein the at least one solar cell (3) is cropped with at least one cutting blade (13).

7. Solar module according to claim 6, **characterized in that** the at least one solar cell (3) is only cropped with at least one cutting blade (13), preferably by mechanical means only.

8. Solar module according to claim 6 or 7, **characterized in that** the at least one solar cell (3) is a wafer-based solar cell, preferably a mono-crystalline solar cell, multi-crystalline solar cell or multi-like mono-crystalline solar cell.

9. Solar module according to claim 6 or 8, **characterized in that** the cropping line (6) of the at least one cropped solar cell (3) runs essentially parallel to at least one of the edges (15) of the solar module.

10. Solar module according to any of the claims 6 to 9, **characterized in that** the cropping line (6) extends at a distance from the edges (15) of the solar module (9).

11. Solar module according to any of the claims 6 to 10, **characterized in that** the solar module (9) contains at least one solar cell (4, 5), preferably multiple identical solar cells without a cropped off portion.

12. Solar module according to any of the claims 6 to 11, **characterized in that** the solar module (9) contains multiple cropped solar cells (3), wherein preferably the solar module (9) contains at least one solar cell (4, 5), preferably multiple identical solar cells without a cropped off portion and the multiple cropped solar cells (3) are cropped from the same type of solar cell as the at least one non-cropped solar cell (4, 5).

13. Solar module according to any of the claims 6 to 12, **characterized in that** at least one solar cell (5), preferably multiple solar cells, being provided that are operatively connected.

14. Solar module according to any of the claims 11 to 13, **characterized in that** at least one cropped solar cell (3) being made from the same type of solar cell as at least one non-cropped solar cell in the module (4, 5).

15. Solar module according to any of the claims 11 to 14, **characterized in that** at least one of the at least one cropped solar cell (3) and/or at least one of the non-cropped solar (4) cells not being operatively connected.

## Patentansprüche

1. Verfahren zur Herstellung eines Solarmoduls (9) bestehend aus den folgenden Schritten:
a) Bereitstellen mindestens einer Solarzelle (3);
b) Bereitstellen einer ersten Schicht eines Verkapselungsmaterials (2);
c) zumindest teilweises Anhaften der mindestens einen Solarzelle (3) an der ersten Schicht des Verkapselungsmaterials (2), wodurch ein Haftabschnitt (14) zwischen der mindestens einen Solarzelle (3) und der ersten Schicht des Verkapselungsmaterials (2) gebildet wird; und
d) Beschneiden der mindestens einen Solarzelle (3), die an der ersten Schicht des Verkapselungsmaterials (2) haftet, in dem Haftabschnitt (14) entlang einer Schnittlinie (6) mit Schneidmitteln (13), wobei Schritt c) vor Schritt d) durchgeführt wird.

2. Verfahren zur Herstellung eines Solarmoduls nach Anspruch 1, **dadurch gekennzeichnet, dass** die Schneidmittel in Schritt d) mindestens eine Schneidklinge (13) umfassen, vorzugsweise nur mindestens eine Schneidklinge (13) umfassen.

3. Verfahren zur Herstellung eines Solarmoduls nach Anspruch 1 oder 2, **dadurch gekennzeichnet, dass** in Schritt c) der Haftabschnitt (14) so gestaltet wird, dass er sich im Wesentlichen über die gesamte Oberfläche der mindestens einen Solarzelle (3) erstreckt.

4. Verfahren zur Herstellung eines Solarmoduls nach einem der vorhergehenden Ansprüche, ferner umfassend den Schritt e) des Bereitstellens einer zweiten Schicht eines Verkapselungsmaterials (11), vorzugsweise vor Schritt c) und vor Schritt d), Anhaften der mindestens einen Solarzelle (3) auf die zweite Schicht des Verkapselungsmaterials (11), vorzugsweise durch Aufbringen von Klebstoff, Hitze, Ultraschall, elektrostatischen Kräften oder einer beliebigen Kombination davon, vorzugsweise während ein Vakuum angelegt wird, und/oder Anhaften der zweiten Schicht des Verkapselungsmaterials (11) an die erste Schicht des Verkapselungsmaterials (2).

5. Verfahren zur Herstellung eines Solarmoduls nach einem der vorhergehenden Ansprüche, **dadurch gekennzeichnet, dass** in Schritt c) die mindestens eine Solarzelle (3), die an der ersten Schicht des Verkapselungsmaterials (2) angehaftet ist, durch Auftragen von Klebstoff, Wärme, Ultraschall, elektrostatische Kräfte oder eine beliebige Kombination davon, darauf angehaftet wird, vorzugsweise während ein Vakuum angelegt wird.

6. Solarmodul (9) umfassend mindestens eine Solarzelle (3) und eine erste Schicht eines Verkapselungsmaterials (2), wobei die mindestens eine Solarzelle (3) zumindest teilweise an der ersten Schicht des Verkapselungsmaterials (2) haftet, wodurch ein Haftabschnitt (14) zwischen der mindestens einen Solarzelle (3) und der ersten Schicht des Verkapselungsmaterials (2) gebildet wird, **dadurch gekennzeichnet, dass** das Solarmodul (9) mit einem Verfahren nach einem der Ansprüche 1 bis 5 hergestellt wird, wobei die mindestens eine Solarzelle (3) mit mindestens einer Schneidklinge (13) beschnitten ist.

7. Solarmodul nach Anspruch 6, **dadurch gekennzeichnet, dass** die mindestens eine Solarzelle (3) nur mit mindestens einer Schneidklinge (13), vorzugsweise nur mechanisch, beschnitten wird.

8. Solarmodul nach Anspruch 6 oder 7, **dadurch gekennzeichnet, dass** die mindestens eine Solarzelle (3) eine Wafer-basierte Solarzelle, vorzugsweise eine monokristalline Solarzelle, multikristalline Solarzelle oder multiähnliche monokristalline Solarzelle ist.

9. Solarmodul nach Anspruch 6 oder 8, **dadurch gekennzeichnet, dass** die Schnittlinie (6) der zumindest einen beschnittenen Solarzelle (3) im Wesentlichen parallel zu zumindest einer der Kanten (15) des Solarmoduls verläuft.

10. Solarmodul nach einem der Ansprüche 6 bis 9, **dadurch gekennzeichnet, dass** die Schnittlinie (6) mit Abstand von den Rändern (15) des Solarmoduls (9) verläuft.

11. Solarmodul nach einem der Ansprüche 6 bis 10, **dadurch gekennzeichnet, dass** das Solarmodul (9) mindestens eine Solarzelle (4, 5), vorzugsweise mehrere identische Solarzellen ohne einen beschnittenen Teilbereich enthält.

12. Solarmodul nach einem der Ansprüche 6 bis 11, **dadurch gekennzeichnet, dass** das Solarmodul (9) mehrere beschnittene Solarzellen (3) enthält, wobei vorzugsweise das Solarmodul (9) mindestens eine Solarzelle (4, 5) enthält, vorzugsweise mehrere identische Solarzellen ohne beschnittenen Teilbereich und die mehreren beschnittenen Solarzellen (3) aus dem gleichen Solarzellentyp beschnitten sind, wie die mindestens eine, nicht beschnittene Solarzelle (4, 5).

13. Solarmodul nach einem der Ansprüche 6 bis 12, **dadurch gekennzeichnet, dass** die mindestens eine Solarzelle (5), vorzugsweise mehrere Solarzellen, vorgesehen sind, in Wirkverbindung stehen.

14. Solarmodul nach einem der Ansprüche 11 bis 13, **dadurch gekennzeichnet, dass** mindestens eine beschnittene Solarzelle (3) aus dem gleichen Solarzellentyp besteht wie mindestens eine unbeschnittene Solarzelle im Modul (4, 5).

15. Solarmodul nach einem der Ansprüche 11 bis 14, **dadurch gekennzeichnet, dass** mindestens eine der mindestens einen beschnittenen Solarzellen (3) und/oder mindestens eine der nicht beschnittenen Solarzellen (4) nicht in Wirkverbindung stehen.

## Revendications

1. Procédé de fabrication d'un module solaire (9) consistant en les étapes suivantes :
a) la fourniture d'au moins une cellule solaire (3) ;
b) la fourniture d'une première feuille d'encapsulation (2) ;
c) l'adhésion, au moins partiellement, de l'au moins une cellule solaire (3) à la première feuille d'encapsulation (2) en formant une partie d'adhésion (14) entre l'au moins une cellule solaire (3) et la première feuille d'encapsulation (2) ; et
d) le rognage de l'au moins une cellule solaire (3) qui adhère à la première feuille d'encapsulation (2) dans la partie d'adhésion (14) le long d'une ligne de rognage (6) avec des moyens de coupe (13), dans lequel l'étape c) est réalisée avant l'étape d).

2. Procédé de fabrication d'un module solaire selon la revendication 1, **caractérisé en ce que** les moyens de coupe dans l'étape d) comprennent au moins une lame de coupe (13), comprennent de préférence seulement au moins une lame de coupe (13).

3. Méthode de fabrication d'un module solaire selon la revendication 1 ou 2, **caractérisé en ce que**, dans l'étape c), on fait s'étendre la partie d'adhésion (14) essentiellement sur la surface complète de l'au moins une cellule solaire (3).

4. Procédé de fabrication d'un module solaire selon l'une quelconque des revendications précédentes, comprenant en outre l'étape e) de fourniture d'une deuxième feuille d'encapsulation (11), de préférence avant l'étape c), et avant l'étape d), l'adhésion de l'au moins une cellule solaire (3) à la deuxième feuille d'encapsulation (11), de préférence en appliquant de la colle, de la chaleur, des ultrasons, des forces électrostatiques ou n'importe quelle combinaison de cela, de préférence alors qu'un vide est appliqué, et/ou l'adhésion de la première feuille d'encapsulation (11) à la deuxième feuille d'encapsulation (2).

5. Procédé de fabrication d'un module solaire selon l'une quelconque des revendications précédentes, **caractérisé en ce que**, dans l'étape c), l'au moins une cellule solaire (3) qui adhère à la première feuille d'encapsulation (2) adhère à celle-ci en appliquant de la colle, de la chaleur, des ultrasons, des forces électrostatiques ou n'importe quelle combinaison de cela, de préférence alors qu'un vide est appliqué.

6. Module solaire (9) comprenant au moins une cellule solaire (3) et une première feuille d'encapsulation (2), dans lequel l'au moins une cellule solaire (3) adhère au moins partiellement à la première feuille d'encapsulation (2) moyennant quoi une partie d'adhésion (14) est formée entre l'au moins une cellule solaire (3) et la première feuille d'encapsulation (2), **caractérisé en ce que** le module solaire (9) est fabriqué avec un procédé selon l'une quelconque des revendications 1 à 5, dans lequel l'au moins une cellule solaire (3) est rognée avec au moins une lame de coupe (13).

7. Module solaire selon la revendication 6, **caractérisé en ce que** l'au moins une cellule solaire (3) est seulement rognée avec au moins une lame de coupe (13), de préférence seulement grâce à des moyens mécaniques.

8. Module solaire selon la revendication 6 ou 7, **caractérisé en ce que** l'au moins une cellule solaire (3) est une cellule solaire à base d'une tranche, de préférence une cellule solaire monocristalline, une cellule solaire multi-cristalline ou une cellule solaire monocristalline de type multiple.

9. Module solaire selon la revendication 6 ou 8, **caractérisé en ce que** la ligne de rognage (6) de l'au moins une cellule solaire rognée (3) s'étend sensiblement parallèlement à au moins l'un des bords (15) du module solaire.

10. Module solaire selon l'une quelconque des revendications 6 à 9, **caractérisé en ce que** la ligne de rognage (6) s'étend à une distance de bords (15) du module solaire (9).

11. Module solaire selon l'une quelconque des revendications 6 à 10, **caractérisé en ce que** le module solaire (9) contient au moins une cellule solaire (4, 5), de préférence une pluralité de cellules solaires identiques sans une partie enlevée par rognage.

12. Module solaire selon l'une quelconque des revendications 6 à 11, **caractérisé en ce que** le module solaire (9) contient une pluralité de cellules solaires rognées (3), dans lequel, de manière préférée, le module solaire (9) contient au moins une cellule solaire (4, 5), de préférence une pluralité de cellules solaires identiques sans partie enlevée par rognage, et la pluralité des cellules solaires rognées (3) sont rognées à partir du même type de cellule solaire que l'au moins une cellule solaire (4, 5) non rognée.

13. Module solaire selon l'une quelconque des revendications 6 à 12, **caractérisé en ce qu'**au moins une cellule solaire (5), de préférence une pluralité de cellules solaires, sont fournies, lesquelles sont connectées de manière fonctionnelle.

14. Module solaire selon l'une quelconque des revendications 11 à 13, **caractérisé en ce qu'**au moins une cellule solaire (3) rognée est constituée du même type de cellule solaire qu'au moins une cellule solaire non rognée dans le module (4, 5).

15. Module solaire selon l'une quelconque des revendications 11 à 14, **caractérisé en ce qu'**au moins une des au moins une cellule solaire (3) rognée et/ou au moins une des cellules solaires (4) non rognées ne sont pas connectées de manière fonctionnelle.
